# EUROPEAN PATENT APPLICATION

(11) **EP 3 879 561 A1**
(43) Date of publication of application: **15.09.2021**
(21) Application number: 20162238.8
(22) Date of filing: 10.03.2020
(51) Int. Cl.: H01L 21/56, H01L 23/16, H01L 23/31

(54) **PROCESS FOR MANUFACTURING AN ELECTRONIC DEVICE**

(71) Applicant: Sensirion AG, 8712 Stäfa (CH)
(72) Inventor: Eichberger, Maximilian, 8712 Stäfa (CH); Merz, Matthias, 8712 Stäfa (CH)
(74) Representative: Toleti, Martin

(57) **Abstract**

A first aspect of the invention relates to a process for manufacturing an electronic device which comprises the following steps: providing a substrate (1); surface mounting an electronic component (2) on the substrate (1), the electronic component (2) having a sensitive area (3); surface mounting a protection cap (5) on the substrate (1), wherein the protection cap (5) covers the sensitive area (3) or an access (211) towards the sensitive area (3); and applying conformal coating to the substrate (1).

A second aspect of the invention relates to an electronic device comprising a coated substrate (1), an electronic component (2) with a sensitive area (3) and one of the following elements, extending over and/or around and/or at the side of the electronic component (2): A surface mounted protection cap (5), a remaining part of a surface mounted protection cap (5), a deformed surface mounted protection cap (5), residue of a mount of a surface mounted protection cap (5).

## Description

### Technical Field

The invention relates to a process for manufacturing an electronic device with an electronic component having a sensitive area; the process includes conformal coating. Furthermore, the invention relates to such electronic device and to a surface mountable cap.

### Background Art

Electronic devices typically comprise a substrate, such as a printed circuit board (PCB), and electronic components on the substrate. A typical problem in manufacturing such device is the following: On the one hand, it is desired to protect the substrate as well as some of the electronic components, e.g. against moisture, dust, chemicals. A known solution is applying a conformal coating on the substrate and the electronic components, e.g. by spraying the coating onto the substrate and/or dipping the substrate into a coating solution. The result is a thin polymeric film which "conforms" to the contours of the substrate and the electronic components. On the other hand, some electronic components comprise a sensitive area which must not be coated, e.g. because this would destroy the sensitive area or hinder measurements performed by the sensitive area. Such components include for instance a light-emitting diode (LED), a vertical-cavity surface-emitting laser (VCSEL), an environmental sensor, e.g. a humidity sensor, or an optical sensor, all of which need unrestricted access to the environment at least with their sensitive area.

Conventionally, the sensitive area of such electronic component is protected during coating by a tape which is peeled off after coating. Such temporary protection is applied and removed manually, and hence is very time-consuming and expensive. Furthermore, such protection is only feasible for electronic components above a certain size, e.g. above a side length of the electronic component of 5 mm. With shrinking electronic devices and ever smaller electronic components, such protection is technically hardly feasible, difficult in handling and becomes unreliable.

Hence it is an object of the present invention to provide a process for manufacturing an electronic device with an electronic component having a sensitive area, which process is more reliable and efficient, and in particular may be automated. Another object relates to an improved electronic device and a component thereof.

### Disclosure of the Invention

This process-related problem is solved by a process for manufacturing an electronic device that comprises the following steps:
- providing a substrate: In particular, the substrate is a PCB (Printed Circuit Board) comprising electronic circuitry.
- surface mounting an electronic component on the substrate, the electronic component having a sensitive area: In particular, the electronic component may in one embodiment be an integrated packaged or unpackaged chip; it preferably comprises a humidity sensor and/or an optical sensor and/or an optical emitter, such as a VCSEL; for the correct functioning of the electronic component, the sensitive area is desired to be accessible from an environment of the electronic component, e.g. in case of a sensor, or vice versa, the sensitive area is desired to access the environment, e.g. in case of an emitter, and in particular, the sensitive area may not be coated.

- surface mounting a protection cap on the substrate, wherein the protection cap covers the sensitive area or an access towards the sensitive area: The protection cap may be embodied in different forms which are detailed below. The protection cap may be mounted to the substrate in the same process step as the electronic component or after.
- applying conformal coating to the substrate: In particular, the conformal coating comprises one or more of acrylic resin, silicone resin, urethane resin, epoxy resin, parylene and a thin film coating. Typically, a thickness of the conformal coating is in the range of 25 to 250 µm. Preferred ways of applying the conformal coating comprise one or more of automated spraying, manual spraying, selective coating, dipping and brushing.

In such process for manufacturing an electronic device, the sensitive area of the electronic component is protected during coating. In particular, the sensitive area is not damaged during coating and stays free of coating, both in a reproducible and reliable manner.

Furthermore, the process is efficient in terms of time and cost since the protection cap may be mounted according to conventional surface mounting technique (SMT). At the same time, the conformal coating ensures a reliable protection of the substrate and/or any electronical components, at least of parts thereof exposed during coating. In particular, the conformal coating protects the substrate against one or more of corrosion, humidity, mechanical degradation, chemical degradation and radiation.

Hence, once dedicated protection of only the relevant sensitive area/s can be provided, the coating process can be simplified, accelerated and made much more reliable. The method can be applied to small scale electronic components, shrinked packages, including chip scale packages. The electronic device can be processed according to surface mount technology and be used for open cavity electronic components and even for delicate top surfaces of electronic components, such as membranes, lenses, etc..

Preferably, the electronic component is small in size, in particular is at most 1.5 mm high, preferably at most 0.5 mm high, and/or at most 5 mm long and/or wide, more preferably at most 1.5 mm long and/or wide. Preferably, the electronic component has the shape of a cuboid, wherein the sensitive area is arranged on or is accessible from a top surface of the cuboid, i.e. comprises an access, also referred to as access opening, in its top surface, hence facing away from the substrate. In this respect, the protection cap covering the sensitive area or the access preferably comprises a horizontal section in parallel to the top surface of the electronic component, a vertical or inclined section supporting the horizontal part, and a base section surface mounted to the substrate from which the vertical or inclined section protrudes. In a different embodiment, the protection cap is bridge shaped and spans the electronic component, and hence has another vertical or inclined section supporting the horizontal section, and another base section mounted to the substrate from which the other vertical or inclined section protrudes.

Preferably, the protection cap is designed and is surface mounted on the substrate so as not to cover or face electrical contacts of the electronic component, in particular not to cover or face electrical contacts of the electronic component exposed on side surfaces of the electronic component. This is beneficial since the electrical contacts, be it side faces of the electrical contacts of the electronic component or solder joints, are desired to be coated. In case the cuboid electronic component comprises electrical contacts only on two opposite sides and the protection cap is bridge shaped, it is preferred that the bridge is arranged relative to the electronic component such that its electrical contacts do not face parts of the protection cap, e.g. its vertical or inclined parts, at least when those parts will remain on the substrate after coating. In a different embodiment, the one or more vertical or inclined parts may be designed thin as to be arranged between the electrical contacts after mounting the protection cap to the substrate. In a different embodiment, the bridge shaped protection cap may be arranged diagonally across the cuboid electronic component, from corner to corner. This may be in particular useful in case the electronic component comprises electrical contacts on all of its four edges.

The protection cap covers the sensitive area or the access thereto. In particular, its horizontal part overlaps the sensitive area or the access thereto at a distance. Such distance or gap may be evoked either by a package of the electronic component wherein the sensitive area is exposed to the environment by the access opening in the package. In this embodiment, the protection cap may or may not be in contact with the package, however, is distant from the sensitive area in view of the package serving for the distance. In a different embodiment, the protection cap may be spaced from the package of the electronic component, if any, or from the unpackaged electronic component. In another embodiment, the protection cap is in contact with the electronic component and covers the electronic component in direct contact. In the latter embodiment it is preferred, that the sensitive area is protected by one or more protection layer/s, such that the protection cap at least does not directly rest on the sensitive area. The protection layer may be designed such that the medium to access the sensitive area still gets there. For example, in case of an optical sensitive area, the protection layer is optically transparent at least in the range of wavelengths to be measured. In case of a humidity or a gas sensor, the protection layer preferably is permeable for the gas desired to be detected.

In an embodiment, the protection cap comprises metal and/or plastics and/or foil. The protection cap may consist of metal. The protection cap, in case of plastics, may at least partly be metallized. The protection cap may be a single piece, or may be made from multiple parts, e.g. glued together. In particular, at least a part of the protection cap may be electrically conducting. As a consequence, the protection cap, or a remaining part, i.e. a part of the protection cap remaining after manufacturing, may serve as ESD and/or EMV protection element for the sensitive area. For this purpose, it is advantageous that the protection element is soldered to a grounded part of the substrate.

In a very preferred embodiment, at least a part, possibly more parts, of the surface mounted protection cap is/are removed or deformed after the coating step, and in particular after the coating has cured, thereby making the sensitive area accessible from an environment. Depending on the form of the protection cap, a part or the whole of it may e.g. be pulled off, bent away or broken in as will become clear from the embodiments described below. In one embodiment, the protection remains fully on the substrate in particular when it is designed such that it protects the sensor opening from the conformal coating and maintains the required access to the sensitive area for the medium to be sensed.

It is advantageous that this step is performed automatically by a dedicated machine.

According to an embodiment, the protection cap comprises a removable part, which is removed after coating and possibly curing, and grants access to the sensitive area for the medium to be sensed. Preferably, the removable part covers the sensitive area during coating. Preferably, a connection between the removable part and a remaining part of the protection cap comprises one or more perforations and/or one or more through-cuts and/ or one or more predetermined breaking points. This makes the removal of the part easier, i.e. less force is required for removing, and ensures the structural integrity of the remaining part. Preferably, the removable part is an integrated part of the protection cap, and hence is manufactured from one piece with the remaining part of the protection cap, the latter is also referred to as body of the protection cap. Preferably, a connection between the removable part and the remaining part - which finally represents the contour of the removable part - does not cross the sensitive area, but remains outside the sensitive area. In general, it is advantageous that the removable part comprises a pull-off lid. In that case, removing the removable part may comprise pulling away the pull-off lid.

Alternatively, the removable part is a part manufactured separate from the body of the protection cap and is attached thereto. It may be a sticker, e.g. a Kapton® sheet, in particular attached to the remaining part by glue, e.g. with a double-side sticky tape. For example, the sticker may cover a hole in the body of the protection cap. Preferably, the sticker is pulled from the body of the protection cap for releasing access to the sensitive area. Furthermore, the sticker can be placed on more than one hole or on a mesh-like structure in the body of the protection cap.

According to a further embodiment, the protection cap comprises a deformable part, which preferably covers the sensitive area during coating and is deformed after coating. Deforming in particular includes bending a part of the protection cap, e.g. the horizontal part or a portion thereof, away from or towards the substrate or to the side. This may be done manually and/or automatically, in particular with a tool. Alternatively, deforming may include breaking in a part of the protection cap, i.e. pushing it towards the substrate. It is advantageous that a connection between the deformable part and a remaining part of the protection cap comprises one or more perforations and/or a predetermined bending seam, which is e.g. thinner than the remaining part of the protection cap, and/or another detachment scheme. This again increases the reliability of the deforming step, thereby making the sensitive area accessible from an environment.

In general, surface mounting the protection cap may comprise soldering or gluing the protection cap to the substrate with at least one soldering point or area or at least one gluing point or area. This may be done during regular SMT (Surface Mounted Technology) processing of the substrate. Preferably, the protection cap and the electronic component both are soldered to the substrate, in the same surface mounting process, i.e. not necessarily concurrently, however, without the substrate leaving the soldering station.

The protection cap can be soldered to the substrate by one or more soldering areas. In case of one soldering area the protection cap may simply be bent upwards after soldering, without the need of a predetermined breaking line.

In a particular embodiment, removing at least a part of the protection cap comprises removing the protection cap as a whole on the at least one soldering point or gluing point. The removal may again be done manually or automatically. Further, it may be supported by a tool. As a result, the finished electronic device may only show the at least one soldering point or gluing point and/or residue thereof, where the protection cap was mounted before.

Further, embodiments of the process differ in the way how the protection cap is arranged with respect to the electronic component. In a first embodiment, the protection cap is mounted in contact with the electronic component, e.g. in contact with a package of the electronic component, in particular with a surface of the package, e.g. of its top side, that exposes the sensitive area, thereby in particular prohibiting any access to the sensitive area.

In a variant, a filler, in particular a foam material, is arranged between the protection cap and the electronic component. The filler preferably is attached to the protection cap, e.g. to a surface of the protection cap facing the electronic component, in particular to the bottom surface of the horizontal part of the protection cap, and in particular to a portion of the bottom surface facing the electronic component outside the sensitive area or the access opening thereto. In a different embodiment, the filler is attached to the entire bottom surface. In this way, it is ensured that the sensitive area does not come into contact with the coating. The filler may be removed together with or separate to the removable part, if any.

In a second embodiment, the protection cap is mounted with a gap to the electronic component, in particular with a gap to a package of the electronic component, in particular with a gap to a surface of the package that exposes the sensitive area. Typically, the coating, e.g. when dipping the substrate into a coating solution, will be pulled into the gap by capillary forces. Advantageously, the gap is dimensioned such that during applying the conformal coating, the coating is pulled into the gap, e.g. by capillary forces. However, the coating may not be pulled to the sensitive area. This may be achieved through a cavity adjacent to the sensitive area, which cavity is wider than the gap, such that the coating may not enter the cavity, e.g. because of surface forces. In an advantageous embodiment, the gap is at most 500 µm wide, and more preferably is at most 250 µm wide.

In a different embodiment, including the gap between the electronic component and the protection cap, the surface of the protection cap facing the electronic component, at least the surface facing the surface of the electronic component including the sensitive area or the access thereto, is coated by an anti-wetting coating, such by a fluoropolymer. Preferably in combination with a proper dimensioning of the gap, this prevents conformal coating from being pulled into the gap.

Preferably, in case of a bridge shaped protection cap, the bridge is aligned to the shape of the electronic component wherein the vertical sections are close to side faces of the electronic component. In another variant, however, the horizontal section is substantially longer than a length of the electronic component, e.g. at least twice as long. In such embodiment, the protection cap may be arranged relative to the electronic component such that the electronic component is arranged close to one of the vertical sections and distant from the other vertical section. Accordingly, there is space between the electronic component and the other vertical section of the protection cap which space can be used as leverage point for a tool for pulling off e.g. the horizontal section in its entirety, or at least parts thereof. In a variant, however, such horizontal section may have two subsections at different heights. Such protection cap may be used for two electronic components different in shape, and in particular different in height, however, not necessarily at the same time. Hence, the protection cap is arranged to cover a first electronic component with a first height in a first scenario, while a different electronic component with a larger height may be covered by the second subsection of the horizontal section of the protection cap in another scenario. Hence, a single protection cap may be used for bridging two differently shaped electronic components, wherein the additional space serves as leverage point in each scenario.

A second aspect of the invention relates to an electronic device which comprises a substrate and an electronic component surface mounted on the substrate. The electronic component has a sensitive area accessible from an environment.

One of the following elements is comprised in the electronic device, as a left over from a protection cap protecting the sensitive area during a previous coating in manufacturing the electronic device: The entire surface mounted protection cap. In this embodiment, the complete protection cap remains mounted on the substrate. This is in particular preferable when the design and / or mounting of such protection cap allows for a sufficient access of the medium to be measured to the sensitive area. This protection cap may extend in particular over and/or around and/or at the side of the electronic component. Preferably, the shape of the protection cap does not change during manufacturing in this variant. In a different variant, the protection cap is deformed during manufacturing such that the deformed surface mounted protection cap remains on the substrate. Hence, the protection cap remains on the substrate after manufacturing in its entirety, however, in a deformed state. Again, this deformed protection cap may extend in particular around and/or at the side of the electronic component, possibly also over the electronic component.

Alternatively, in case the protection cap has a removable part removed after coating during manufacturing, a remaining part of a surface mounted protection cap remains surface mounted on the substrate. This remaining part of the protection cap may extend in particular over and/or around and/or at the side of the electronic component.

Alternatively, and in particular when the entire protection cap is removed after coating, a residue of a mount of such surface mounted protection cap may remain.

Accordingly, in agreement with the above description, the residue of the surface mounted protection cap may in an extreme case only comprise at least one soldering point or area or gluing point or area, or remainders thereof, with which the protection cap has previously been soldered or glued to the substrate.

Given that the electronic device was exposed to a coating step during manufacturing, at least a part of the substrate, and in particular the exposed surfaces of the substrate, show a conformal coating, whereas the sensitive area is free from the conformal coating. In a variant, exposed surfaces of the electronic component, e.g. including exposed electrical contacts or solder points, may be coated as well.

According to a further aspect of the present invention, a surface mountable cap is provided for protecting a sensitive area of an electronic component to be co-arranged with the cap on a substrate. The protection cap shall protect the electronic component from conformal coating applied to the substrate. The surface mountable cap comprises one of a removable part and a deformable part. Preferably, the cap comprises one or more surface mountable base sections, oriented horizontally for enabling the cap to sit and be mounted to a circuit board, e.g. by soldering. In one embodiment, each base section preferably includes electrically conducting soldering areas which, in combination with a solder, enable a mechanical and/or electrical connection to a corresponding contact pad of the circuit board.

Preferably, the removable part is an integrated part of the protection cap, and may be embodied as a pull-off lid. A connection between the removable part and a remaining part of the protection cap comprises perforations or a predetermined breaking point. In a different embodiment, the removable part is a part separate from a remaining part of the protection cap and is attached thereto such as a sticker.

In case of a deformable part, it is preferred that a connection between the deformable part and a remaining part of the protection cap comprises perforations or a predetermined bending seam.

The protection cap preferably is a protection cap used in the electronic device according to any of the above or below embodiments, and/or in the process for manufacturing an electronic device according to any of the above or below embodiments. Accordingly, usage of such protection cap is claimed accordingly.

The device may in particular be manufactured according to embodiments of the method described above.

In an embodiment, the remaining part of the protection cap comprises a membrane covering the sensitive area of the electronic component. Such membrane may e.g. be permeable for gas and/or humidity. In particular, the membrane may permanently protect the sensitive area from degradation, e.g. through dust, mechanical damage or radiation.

Technical features disclosed in the context of the method are to be understood as disclosed in the context of the device and the protection cap as well, and vice versa. Other advantageous embodiments are listed in the dependent claims as well as in the description below.

### Brief Description of the Drawings

The invention will be better understood and objects other than those set forth above will become apparent from the following detailed description thereof. Such description makes reference to the annexed drawings, wherein:
Fig. 1 shows a sketch of an electronic component with a sensitive area mounted on a substrate according to the prior art, in perspective view;
Figs. 2 to 9 show sketches of an electronic device with a sensitive area covered by a protection cap according embodiments of the invention, in perspective views;
Fig. 10 shows a flow chart of a process for manufacturing an electronic device according to an embodiment of the invention.

### Modes for Carrying Out the Invention

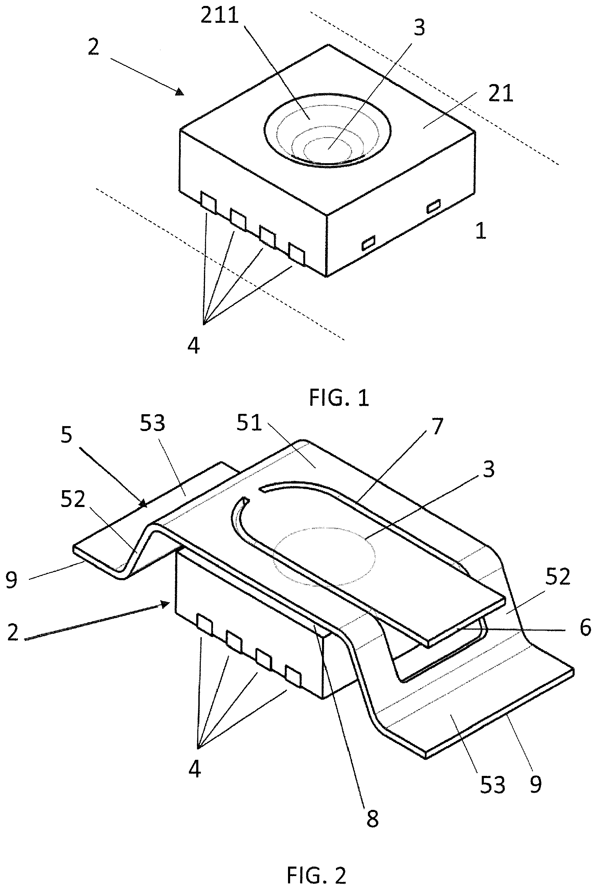

Fig. 1 depicts a conventional electronic component 2 comprising a chip with a sensitive area 3, e.g. a sensitive surface. The electronic component 2 comprises a package 21 around the chip which package 21 includes an access opening 211 for granting access to the sensitive area 3. The electronic component 2 is mounted on a substrate 1, e.g. a PCB, by applying SMT. The electronic component 2 has electric contacts 4 exposed from the package 211 which electrical contacts 4 are soldered to the substrate 1, in particular to electric circuitry within or on the substrate 1. The assembly of Fig. 1 typically is part of an electronic device.

The electronic component 2 may in particular be an environmental sensor, e.g. for sensing humidity or gas. For a regular function, the sensitive area 3 is desired to be in contact with the environment of the electronic component 2. In particular, the sensitive area 3 may not be covered by any coating that is applied to the substrate 1 and/or the electronic component 2 during manufacturing for protection purposes. Since the coating is often applied as conformal coating, e.g. by spraying or dipping, the sensitive area 3 is held free from coating during the coating step by a protection cap according to the present invention. In the following, different embodiments of such protection cap are described, and shall also be considered as disclosed on its own absent the electronic component it protects.

### 1^{st} embodiment

Fig. 2 shows an electronic component 2 with a sensitive area 3 (not visible) covered by a protection cap 5 according to a 1^{st} embodiment. The protection cap 5 is made of metal and soldered to the substrate 1 (not visible) in SMT by two soldering areas 9. The protection cap 5 is bridge shaped, bridges the electronic component 2, and comprises a horizontal section 51, two inclined sections 52, and two base sections 53, all manufactured integrally, e.g. from one piece of material by bending the various sections. The protection cap 5 in addition comprises a pull-off lid 6, i.e. a removable part, e.g. also manufactured integrally with the other sections of the protection cap 5, preferably arranged in the horizontal section 51. The sensitive area 3 faces the bottom side of the horizontal section 51, and in particular faces the pull-off lid 6. Hence, the pull-off lid 6 is in particular arranged so as a cover or protection for the sensitive area 3 during the coating step. The pull-off lid 6 is pulled off, i.e. removed, after the coating is applied, in particular after the coating is cured. To facilitate the pulling-off, the pull-off lid 6 comprises a protruding section which may easily be held by hand or a tool. In particular, this allows for an automated removal of the pull-off lid 6 or several pull-off lids at the same time, which makes the manufacturing process more efficient in terms of time and cost. Also it allows for a miniaturization of the electronic device and in particular of the electronic component 2 and the protection cap 5.

In general, the material of the protection cap 5 may comprise plastics and/or foil alternative or in addition to metal, e.g. a metallized foil. Also, the protection cap 5 may be glued to the substrate 1 instead of soldered. In general, due to the way of mounting the protection cap 5 to the substrate 1, there is at least one soldering point or area 9 or gluing point or area provided by the protection cap 5, preferably horizontally oriented.

The protection cap 5 of Fig. 2 exhibits two further advantageous features. Firstly, it comprises a perforation 7 between the pull-off lid 6 and the remaining part of the protection cap 5 after pulling-off. The perforation 7 may be embodied as small holes (not shown in detail) punched into the protection cap 5 along a line separating the pull-off lid 6 and the remaining part. In general, the perforation 7 acts as a predetermined breaking line along which the pull-off lid 6 is easily pulled off.

Secondly, the protection cap 5 of Fig. 2 is not mounted flush, i.e. in direct contact with the electronic component 2, but at a small distance, such that a gap 8 is formed between the protection cap 5 and the electronic component 2, and in particular between the protection cap 5 and a package of the electronic component 2; the width of the gap 8 is at most 250 µm. Due to the small width of the gap 8, the coating may be pulled into the gap 8 by capillary forces during the coating step, but the coating does not propagate all the way to the sensitive area 3, in particular since surface forces hinder it to spread into the larger cavity above the sensitive area 3 and behind the gap 8. In this way, a reliable coating of all desired parts, i.e. the substrate 1 and at least parts of the electronic component 2 is achieved. Note that the electric contacts 4 of the electronic component 2 are not covered or faced by the protection cap 5 in this embodiment; hence they are coated, which is desired for protection purposes.

Furthermore, the protection cap 5 of Fig. 2, if comprising metal, may act as ESD or EMV protection of the electronic component 2 and in particular of the sensitive area 3. This is due to the shape of the remaining part which encircles the sensitive area 3. For acting as ESD protection, it is advantageous that the protection cap 5 is soldered to a ground contact of the substrate 1.

### 2^{nd} embodiment

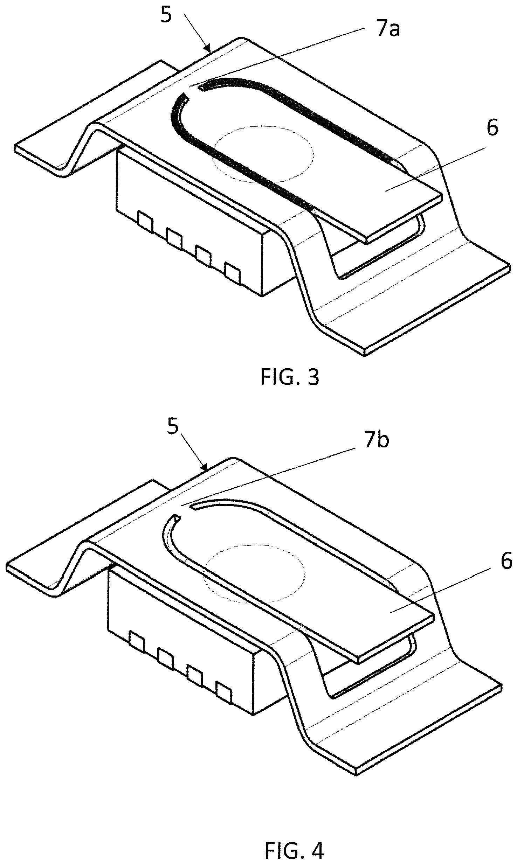

Fig. 3 shows a 2^{nd} embodiment of the protection cap 5, which is a variant of the above 1^{st} embodiment. The 2^{nd} embodiment differs from the 1^{st} embodiment in the connecting element between the pull-off lid 6 and the remaining part of the protection cap 5: Here, the protection cap 5 comprises a tapered predetermined breaking point 7a for an easy removal of the pull-off lid 6. I.e. the breaking point 7a is achieved by a tapered connection between the pull-off lid 6 and the remaining part of outside the breaking point 7a, as indicated by the dark line. In a way, the tapered predetermined breaking point 7a resembles the connection of the seal of a drinking can.

Such protection cap 5 is particularly useful for a metallic protection cap. It facilitates the cut-free removal of the pull-off lid 6.

### 3^{rd} embodiment

Fig. 4 shows a 3^{rd} embodiment of the protection cap 5, which again is a variant of the above 1^{st} and 2^{nd} embodiments. Here, the connecting element between the pull-off lid 6 and the remaining part of the protection cap 5 is a punched predetermined breaking point 7b. I.e. the breaking point 7b is achieved by punching a connection between the pull-off lid 6 and the remaining part of outside the breaking point 7b. This is again particularly useful for a metallic protection cap, facilitating the cut-free removal of the pull-off lid 6.

### 4th embodiment

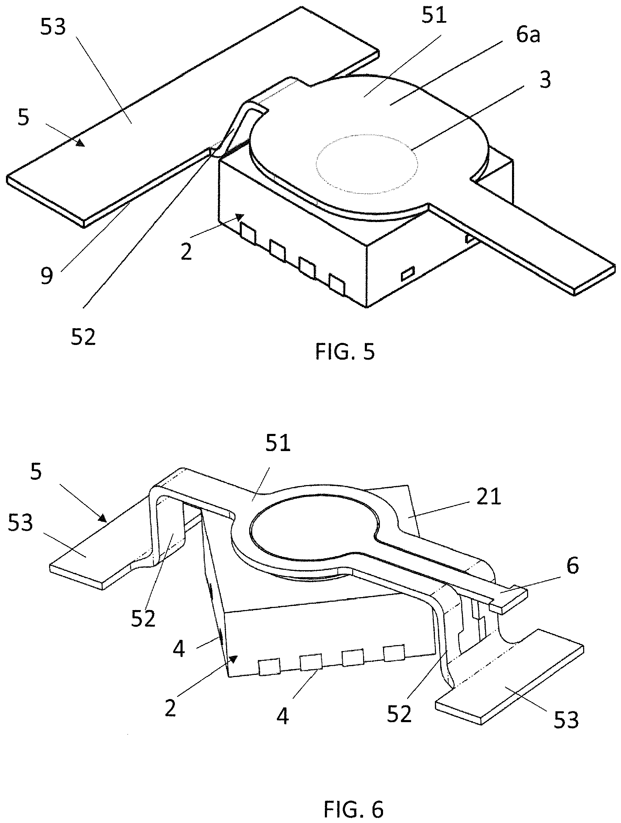

Fig. 5 shows a protection cap 5 according to a 4^{th} embodiment of the invention. The protection cap 5 comprises a single base section 53, a single inclined section 52 protruding from the base section 53. The protection cap 5 is soldered to the substrate 1 (not visible) with a single soldering area 9. Further, the protection cap 5 comprises a horizontal section 51 serving as bend-away lid 6a. Preferably, the protection cap 5 is made from one piece of material. During coating, the bend-away lid 6a covers the sensitive area 3 (not visible, underneath the bend-away lid 6a). After coating, the bend-away lid 6a is bent away, i.e. upwards and away from the electronic component 2, such that the sensitive area 3 is accessible from the environment.

The protection cap 5 may contain one or more predetermined bending lines or bending areas in order to ease the bending-away of deformation of the bend-away lid 6a. A bending line may e.g. be achieved through grooving. The protection cap 5 shown in Fig. 5 is also referred to as "Z-design" due to its shape and the two predetermined bending lines.

In general, a protection cap 5 with a shape according to the 4^{th} embodiment may also be implemented with a pull-off lid instead of a bend-away lid. In that case, the protection cap 5 may contain a predetermined breaking point in one of the variants described for the 1^{st} to 3^{rd} embodiments.

### 5th embodiment

Fig. 6 shows a 5^{th} embodiment of the protection cap 5, which is particularly useful for an electronic component 2 with electric contacts 4 on all four sides of the package 21 of the electronic component 2. In order to facilitate the coating of all electric contacts 4, the bridge shaped protection cap 5 is mounted diagonally over the electronic component 2, from one corner to the opposite corner.

The protection cap 5 of Fig. 6 comprises a pull-off lid 6, which may easily be pulled off due to a perforation 7, cf. the 1^{st} embodiment. The shape of the protection cap 5 may also be implemented as Z-design. Alternatively, a protection cap 5 similar to the 5^{th} embodiment may comprise a bend-away lid, cf. the 4^{th} embodiment, wherein the lid is not completely removed after coating but only deformed, and in particular bent away, e.g. away from the electronic component 2 or to the side of it.

### 6th embodiment

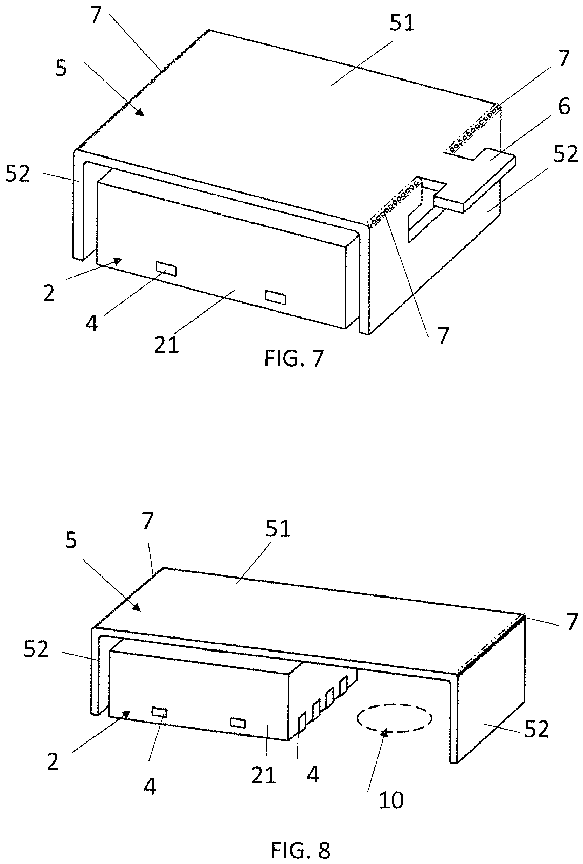

Fig. 7 shows a protection cap 5 according to a 6^{th} embodiment. The protection cap 5 again is bridge shaped, comprising a horizontal section 51, two vertical sections 52, and two base sections (not shown, but to be extended horizontally from both vertical sections 52, comparable to the base sections 51 in Figures 2 to 4), which are soldered or glued on the substrate 1 (not visible) on opposite sides of the electronic component 2 similar as in the 1^{st} embodiment. However, the width of the soldering areas 9 or gluing areas does not exceed the width of the electronic component 2. This is advantageous in view of the ever shrinking electronic devices and components.

Furthermore, the 6^{th} embodiment exhibits a pull-off lid 6 with a protruding part and perforations 7 or precuts, facilitating an easier removal of the lid 6. In this embodiment, the entire horizontal section 51 is pulled away, and the entire top surface of the electronic component becomes exposed after the removal. The remaining part of the protection cap 5 includes the base sections 53 and the vertical sections 52.

### 7th embodiment

Fig. 8 shows a 7^{th} embodiment of the protection cap 5, which is in many aspects similar to the 6^{th} embodiment. The protection cap 5 again comprises a pull-off lid 6 to be removed after coating. The removal is simplified by perforations 7 or precuts at the bent edges of the protection cap 5 between the horizontal section 51 and the vertical sections 52. The area in between adjacent perforations 7 or precuts may be seen as predetermined breaking points 7b, cf. the 3^{rd} embodiment.

The 7^{th} embodiment differs from the 6^{th} embodiment in that one of the soldering areas 9 (not shown, but to be extended horizontally at base sections from both vertical sections 52, comparable to the base sections 51 in Figures 2 to 4), is not arranged directly adjacent to the electronic component 2 but with a distance to it. This means that the protection cap 5 spans over more space than only the electronic component 2. This space may be used for removing the pull-off lid 6 with the help of a tool, e.g. tweezers. Accordingly, the 7^{th} embodiment contains a leverage point 10 for a tweezer or a different tool between the substrate 1 and the protection cap 5. This simplifies a removal of the latter and relieves the need for a protruding part of the pull-off lid 6 as in the 6^{th} embodiment.

In another variant of the embodiment of Fig. 8, the horizontal section 51 may have two subsections at different heights. For example, the non-occupied space with the leverage point 10 may be bridged by a subsection which exceeds the subsection of the horizontal section 51 that covers the electronic component 2. Accordingly, such protection cap 5 may be used for two electronic components different in shape, and in particular different in height. Hence, the protection cap 5 is arranged to cover a first electronic component with a first height such as the one shown in Fig. 8 by the first subsection of the horizontal section 51, while a different electronic component with a height larger than the one shown in Fig. 8 may be covered by the second subsection of the horizontal section of the protection cap 5. Hence, a single protection cap 5 may be used for bridging two different shaped electronic components, wherein the additional space serves as leverage point 10 each time.

### 8th embodiment

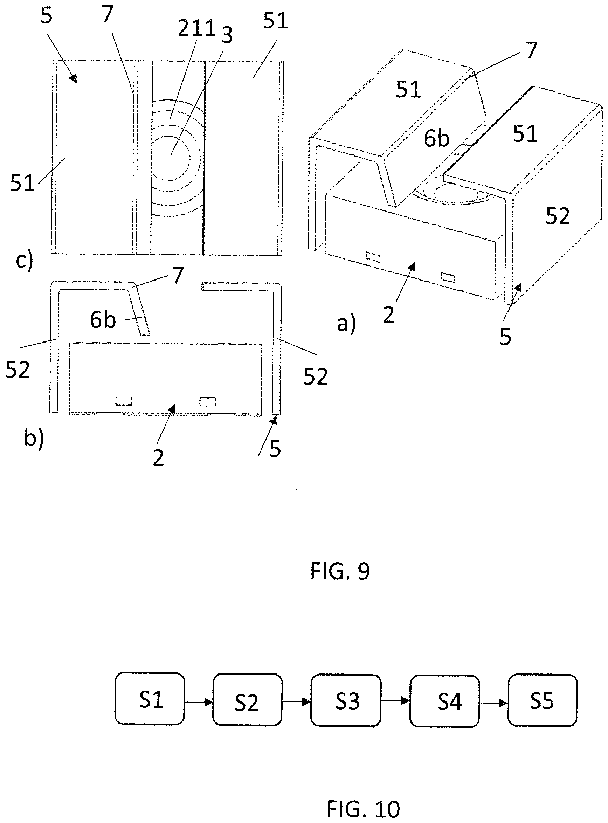

Fig. 9 shows a protection cap 5 according to an 8^{th} embodiment of the invention, in a perspective view in diagram a), in a cut view in diagram b), and in a top view in diagram c). Such protection cap 5 again comprises a horizontal section 51 supported by two vertical sections 52, and hence is bridge shaped. This protection cap 5 comprises a part 6b in the horizontal section 51 which may be broken in after coating. The broken-in part 6b may remain attached to the rest of the protection cap 5 similar to the bend-away lid of the 4^{th} embodiment such that the deformed protection cap 5 remains surface mounted on the substrate 1. Alternatively, the broken-in part 6b may be removed, and the remaining part of the protection cap 5 remains surface mounted on the substrate 1. The breaking-in may again be simplified by a perforation 7 or a precut. As can be derived from Fig. 9, the part 6b to be broken in is arranged offset from the sensitive area 3, or an access opening 211 to the sensitive area 3 respectively.

The 8^{th} embodiment may be advantageous for an automated manufacturing of small electronic devices, wherein the electronic component 2 e.g. has a side length of smaller than 2 mm. Also, it may be advantageous for batch processing of several protection caps since breaking in of the parts 6b may reliably be achieved by pushing a tool with suitable studs against the protection caps.

### Manufacturing process

Fig. 10 shows a flow chart of a manufacturing process for an electronic device that comprises a substrate and an electronic component with a sensitive area, e.g. as described above. In step S1, a substrate is provided, e.g. in the form of a conventional PCB with conductor tracks on or within the PCB. The PCB is in particular designed for the specific electronic device. In step S2, the electronic component with the sensitive area as well as possibly further electronic components is mounted on the substrate by conventional SMT. This may include soldering and/or gluing components to the substrate.

In step S3, a protection cap covering the sensitive area is surface mounted on the substrate. Step S3 may alternatively be performed simultaneously with step S2. The protection cap may be embodied in various forms, e.g. the ones described with respect to the 1^{st} to 8^{th} embodiment. Accordingly, the protection cap is either soldered or glued to the substrate with one or more soldering or gluing points.

In step S4, the substrate and potentially uncovered parts of the electronic component and the protection cap are coated by conformal coating. Typically, this is done by spraying the coating onto the substrate or by dipping the substrate into the coating. The conformal coating typically results in a coating layer of a thickness in the range between 25 to 250 µm. Afterwards, the coating needs to be cured, e.g. by drying, by heat and/or radiation. The curing step may be performed before or after step S5.

In step S5, at least a part of the protection cap is removed or deformed such that the sensitive area is accessible from the environment. With that, the electronic component may be fully functional; in particular, the sensitive area is free of coating. At the same time, the desired parts like the substrate and possibly other electronic components are coated and thus protected, e.g. against mechanical damage, chemicals, corrosion, temperature extremes and/or radiation.

An advantage of such process is that it may be automated. The mounting of the protection cap can in particular be implemented in conventional SMT processing, and the removing or deforming of at least a part of the protection cap may be supported by suitable tools.

## Claims

1. Process for manufacturing an electronic device, comprising the steps of
- providing a substrate (1),
- surface mounting an electronic component (2) on the substrate (1), the electronic component (2) having a sensitive area (3),
- surface mounting a protection cap (5) on the substrate (1), wherein the protection cap (5) covers the sensitive area (3) or an access (211) towards the sensitive area (3),
- applying conformal coating to the substrate (1) .

2. Process according to claim 1, comprising
- removing or deforming at least a part of the protection cap (5), thereby making the sensitive area (3) accessible from an environment,
in particular wherein removing or deforming the at least part of the protection cap (5) is performed automatically by a dedicated machine.

3. Process according to claim 2,
wherein the protection cap (5) comprises a removable part (6),
preferably wherein the removable part (6) covers the sensitive area (3) during coating and is removed after coating,
in particular wherein the removable part (6) is an integrated part of the protection cap (5),
in particular wherein a connection between the removable part (6) and a remaining part of the protection cap (5) comprises one or more perforations and/or one or more through-cuts (7) and/or one or more predetermined breaking points (7a, 7b), and/or
wherein the removable part (6) comprises a pull-off lid,
in particular wherein removing the removable part (6) comprises pulling away the pull-off lid.
in particular wherein the removable part (6) is a part separate from a remaining part of the protection cap (5) and is attached thereto,
in particular wherein the removable part (6) is a sticker,
in particular wherein removing the removable part (6) comprises pulling away the sticker.

4. Process according to claim 2,
wherein the protection cap (5) comprises a deformable part (6a), which is deformed with respect to a remaining part after coating,
in particular wherein a connection between the deformable part (6a) and the remaining part of the protection cap (5) comprises one or more perforations and/or another detachment scheme (7) and/or a predetermined bending seam.

5. Process according to claim 2,
wherein removing at least a part of the protection cap (5) comprises removing the protection cap (5) as a whole on the at least one soldering point (9).

6. Process according to any of the preceding claims,
wherein surface mounting the electronic component (2) on the substrate (1) comprises soldering the electronic component to the substrate (1),
wherein surface mounting the protection cap (5) on the substrate (1) comprises soldering the protection cap (5) to the substrate (1) with at least one soldering point (9),
wherein soldering the electronic component (2) and the protection cap (5) is performed within the same surface mounting process.

7. Process according to any of the preceding claims,
wherein the protection cap (5) comprises metal and/or plastics and/or foil,
in particular wherein the protection cap (5) is at least partly metallized, and/or
in particular wherein the protection cap (5) or a remaining part thereof serves as ESD protection element for the sensitive area (3) after manufacturing.

8. Process according to any of the preceding claims,
wherein the protection cap (5) is mounted in contact with the electronic component (2), in particular in contact with a package (21) of the electronic component (2), in particular in contact with a surface of the package (21) that exposes the sensitive area (3), in particular prohibiting any access to the sensitive area (3),
in particular wherein the protection cap (5) includes a filler, in particular a foam material, arranged at a side of the protection cap (5) facing the electronic component (2), and in particular facing a surface of the package (21) of the electronic component (2) exposing the sensitive area (3).

9. Process according to any of claims 1 to 7,
wherein the protection cap (5) is mounted with a gap (8) to the electronic component (2), in particular with a gap (8) to a package (21) of the electronic component (2), in particular with a gap (8) to a surface of the package (21) that exposes the sensitive area (3),
in particular wherein the gap (8) is at most 500 µm wide, and more preferably is at most 250 µm wide
in particular wherein the gap (8) is dimensioned such that during applying the conformal coating, the coating is pulled into the gap (8) but not to the sensitive area (3).

10. Process according to any of the preceding claims,
wherein applying conformal coating comprises one or more of automated spraying, manual spraying, selective coating, dipping and brushing.
in particular wherein the conformal coating comprises one or more of acrylic resin, silicone resin, urethane resin, epoxy resin, parylene and thin film coating, and
in particular wherein a thickness of the conformal coating is in a range of 25 to 250 µm.

11. Process according to any of the preceding claims,
wherein the protection cap (5) is designed and is surface mounted on the substrate (1) so as not to cover or face electrical contacts of the electronic component (2), in particular not to cover or face electrical contacts (4) of the electronic component (2) exposed on side surfaces of the electronic component (2).

12. Electronic device, in particular manufactured according to the method of any of the preceding claims, comprising
- a substrate (1),
- an electronic component (2) surface mounted on the substrate (1), the electronic component (2) having a sensitive area (3) accessible from an environment,
- a conformal coating on the substrate (1), wherein the sensitive area (3) is free from the conformal coating,
- one of the following elements, extending over and/or around and/or at the side of the electronic component (2):
- a surface mounted protection cap (5),
- a remaining part of a surface mounted protection cap (5),
- a deformed surface mounted protection cap (5),
- residue of a mount of a surface mounted protection cap (5).

13. Device according to claim 12,
wherein the conformal coating is adapted to protect the substrate (1) against one or more of corrosion, humidity, mechanical degradation, chemical degradation and radiation.

14. Device according to claim 12 or 13,
wherein the electronic component (2) comprises a humidity sensor and/or an optical sensor,
in particular wherein the electronic component (2) is at most 1.5 mm high, and more preferably is at most 0.5 mm high and/or
in particular wherein the electronic component (2) is at most 5 mm long and/or wide, and more preferably is at most 1.5 mm long and/or wide.

15. A surface mountable cap (5) for protecting a sensitive area (3) of an electronic component (2) to be co-arranged with the protection cap on a substrate (1) from conformal coating applied to the substrate (1), comprising one of a removable part (6) and a deformable part (6a),
in particular comprising one or more surface mountable areas,
in particular wherein the removable part (6) is an integrated part of the protection cap (5),
in particular wherein a connection between the removable part (6) and a remaining part of the protection cap (5) comprises perforations (7) or a predetermined breaking point (7a, 7b),
in particular wherein the removable part (6) comprises a pull-off lid,
in particular wherein the removable part (6) is a part separate from a remaining part of the protection cap (5) and is attached thereto,
in particular wherein the removable part (6) is a sticker,
in particular wherein a connection between the deformable part (6a) and a remaining part of the protection cap (5) comprises perforations (7) or a predetermined bending seam.

## Amended claims

### Amended claims in accordance with Rule 137(2) EPC.

1. Process for manufacturing an electronic device, comprising the steps of
- providing a substrate (1),
- surface mounting an electronic component (2) on the substrate (1), the electronic component (2) having a sensitive area (3),
- surface mounting a protection cap (5) on the substrate (1), wherein the protection cap (5) covers the sensitive area (3) or an access (211) towards the sensitive area (3),
- applying conformal coating to the substrate (1),
- removing or deforming at least a part of the protection cap (5), thereby making the sensitive area (3) accessible from an environment.

2. Process according to claim 1,
wherein the protection cap (5) comprises a removable part (6),
wherein the removable part (6) is an integrated part of the protection cap (5),
wherein a connection between the removable part (6) and a remaining part of the protection cap (5) comprises one or more perforations and/or one or more through-cuts (7) and/or one or more predetermined breaking points (7a, 7b),
wherein the removable part (6) comprises a pull-off lid,
wherein removing the removable part (6) comprises pulling away the pull-off lid.

3. Process according to claim 1,
wherein the protection cap (5) comprises a removable part (6),
wherein the removable part (6) is a part separate from a remaining part of the protection cap (5) and is attached thereto,
wherein the removable part (6) is a sticker,
wherein removing the removable part (6) comprises pulling away the sticker.

4. Process according to claim 1,
wherein the protection cap (5) comprises a deformable part (6a), which is deformed with respect to a remaining part after coating,
wherein a connection between the deformable part (6a) and the remaining part of the protection cap (5) comprises one or more perforations and/or another detachment scheme (7) and/or a predetermined bending seam.

5. Process according to claim 1,
wherein removing at least a part of the protection cap (5) comprises removing the protection cap (5) as a whole on the at least one soldering point (9).

6. Process according to any of the preceding claims,
wherein surface mounting the electronic component (2) on the substrate (1) comprises soldering the electronic component to the substrate (1),
wherein surface mounting the protection cap (5) on the substrate (1) comprises soldering the protection cap (5) to the substrate (1) with at least one soldering point (9),
wherein soldering the electronic component (2) and the protection cap (5) is performed within the same surface mounting process.

7. Process according to any of the preceding claims,
wherein the protection cap (5) comprises metal and/or plastics and/or foil.

8. Process according to any of the preceding claims,
wherein the protection cap (5) is mounted in contact with the electronic component (2),
wherein the protection cap (5) includes a filler arranged at a side of the protection cap (5) facing the electronic component (2).

9. Process according to any of claims 1 to 7,
wherein the protection cap (5) is mounted with a gap (8) to the electronic component (2),
wherein the gap (8) is dimensioned such that during applying the conformal coating, the coating is pulled into the gap (8) but not to the sensitive area (3) .

10. Process according to any of the preceding claims,
wherein applying conformal coating comprises one or more of automated spraying, manual spraying, selective coating, dipping and brushing,
wherein the conformal coating comprises one or more of acrylic resin, silicone resin, urethane resin, epoxy resin, parylene and thin film coating, and
wherein a thickness of the conformal coating is in a range of 25 to 250 pm.

11. Process according to any of the preceding claims,
wherein the protection cap (5) is designed and is surface mounted on the substrate (1) so as not to cover or face electrical contacts of the electronic component (2).

12. Electronic device manufactured according to the method of any of the preceding claims, comprising
- a substrate (1),
- an electronic component (2) surface mounted on the substrate (1), the electronic component (2) having a sensitive area (3) accessible from an environment,
- a conformal coating on the substrate (1), wherein the sensitive area (3) is free from the conformal coating,
- one of the following elements, extending over and/or around and/or at the side of the electronic component (2):
- a surface mounted protection cap (5),
- a remaining part of a surface mounted protection cap (5),
- a deformed surface mounted protection cap (5),
- residue of a mount of a surface mounted protection cap (5).

13. Device according to claim 12,
wherein the conformal coating is adapted to protect the substrate (1) against one or more of corrosion, humidity, mechanical degradation, chemical degradation and radiation.

14. Device according to claim 12 or 13,
wherein the electronic component (2) comprises a humidity sensor and/or an optical sensor,
wherein the electronic component (2) is at most 1.5 mm high, and/or
wherein the electronic component (2) is at most 5 mm long and/or wide.

15. A surface mountable cap (5) for protecting a sensitive area (3) of an electronic component (2) to be co-arranged with the protection cap on a substrate (1) from conformal coating applied to the substrate (1), comprising one of a removable part (6) and a deformable part (6a),
comprising one or more surface mountable base sections oriented horizontally for enabling the cap to sit on and be mounted to a circuit board, wherein each base section includes electrically conducting soldering areas for enabling, in combination with a solder, a mechanical and/or electrical connection to a corresponding contact pad of the circuit board.
